# EUROPEAN PATENT APPLICATION

(11) **EP 0 786 811 A1**
(43) Date of publication of application: **30.07.1997**
(21) Application number: 96926616.2
(22) Date of filing: 09.08.1996
(51) Int. Cl.: H01L 27/04

(54) **METHOD OF MANUFACTURING SEMICONDUCTOR INTEGRATED CIRCUIT**

(30) Priority: 11.08.1995 JP 206325/95
(71) Applicant: Seiko Instruments R&D Center Inc., Chiba-shi, Chiba 261 (JP)
(72) Inventor: AKAMINE, Tadao Seiko Instruments R & D Center, Chiba 261 (JP); HARADA, Hirofumi Seiko Instruments R & D Center, Chiba 261 (JP); SATO, Keiji Seiko Instruments R & D Center Inc., Chiba 261 (JP); INOUE, Masahiro Seiko Instruments R & D Center, Chiba 261 (JP); YAMANAKA, Junko Seiko Instruments R & D Center, Chiba 261 (JP); SAITO, Yutaka Seiko Instruments R & D Center Inc., Chiba 261 (JP)
(74) Representative: Sturt, Clifford Mark
(86) International application number: JP9602264
(87) International publication number: WO9707545

(57) **Abstract**

Manufacture is made of a semiconductor integrated circuit wherein the sheet resistivity of the polycrystalline silicon is low and the reproducibility of this sheet resistivity is very high. A manufacturing method for manufacturing the semiconductor integrated circuit is comprised of a step of forming a silicon nitride film on a metal wiring by the use of a plasma CVD method and a step of, after having had the silicon nitride film, performing heat treatment with respect to the resulting structure at a temperature of from 400 °C to 480 °C.

## Description

### Technical Field

The present invention relates to a manufacturing method for manufacturing a semiconductor integrated circuit that uses a polycrystalline silicon film as the resistance element.

### Technical Background

In a conventional manufacturing method for manufacturing a semiconductor integrated circuit that uses a polycrystalline silicon film as the resistance element, before or after the formation of a silicon nitride film that serves as the passivation film, heat treatment was performed in a hydrogen atmosphere of from 400 °C to 480 °C for half an hour to one hour as a step for decreasing the contact resistance between the metal wiring and the silicon and for decreasing the interfacial level between the silicon oxide film and the silicon.

In a conventional manufacturing method for manufacturing a semiconductor integrated circuit that uses a polycrystalline silicon film as the resistance element, when forming a polycrystalline silicon film having a sheet resistivity of 10 k Ω /□ or more, there exists the problem to be solved that the variation in the sheet resistivity is large and hence the reproducibility thereof is poor.

Under the conditions in which there is performed a doping for the formation of a polycrystalline silicon film having a sheet resistivity of 10 k Ω /□ or more, the trap level density in the grain boundary layer in the polycrystalline silicon is very high. In the heat treatment of from half an hour to one hour or so that has hitherto been performed in a hydrogen atmosphere of from 400 °C to 480 °C, the termination of the trap levels due to the diffusion of hydrogen from the silicon nitride film that has been formed using a plasma CVD method into the polycrystalline silicon film that becomes a future resistance element is insufficient. As a result, many trap levels are left as are without being terminated. Also, because of the amount of hydrogen diffused being difficult to control, the proportion of the terminated trap leves based on each unit area varies within the substrate or between the substrates. This has increased the variation in the sheet resistivity and made the reproducibility thereof poor.

### Disclosure of the Invention

In order to solve the above-mentioned problems, the present invention has adopted the following means.

As first means, there has been executed a step in which, after a silicon nitride film that serves as the passivation film has been formed with the use of a plasma CVD method, heat treatment is performed at 400 °C to 480 °C for at least 24 hours.

As second means, there has been executed a step in which, after having formed a metal wiring and before forming the silicon nitride film that serves as the passivation film, hydrogen plasma treatment is performed at a substrate temperature of 400 °C to 480 °C.

The following functions are obtained by adopting the above-mentioned means.

By adopting the above-mentioned first means, since the amount of hydrogen diffused from the silicon nitride film that has been formed using the plasma CVD method into the polycrystalline silicon film that serves as a future resistance element becomes sufficiently increased with the result that almost all trap levels in the grain boundary layer in the polycrystalline silicon are terminated by the hydrogen thus diffused, the variation in the sheet resistivity becomes small whereby excellent reproducibility thereof is obtained.

By adopting the above-mentioned second means, the same effect as that which is attainable with the first means is obtained in a shorter period of time than that in the case of the first means.

As has been explained above, according to the present invention, there is obtained a semiconductor integrated circuit wherein the variation in the sheet resistivity of the polycrystalline silicon is small and the reproducibility thereof is very excellent.

### Brief Description of the Drawings

Figs. 1(a) to 1(e) are sequential order step sectional views illustrating a manufacturing method for manufacturing a semiconductor integrated circuit according to a first embodiment of the present invention;
Figs. 2(f) to 2(i) are sequential order step sectional views illustrating a manufacturing method for manufacturing a semiconductor integrated circuit according to a first embodiment of the present invention;
Fig. 3 is a graphic diagram illustrating the dependency of the sheet resistivity of the polycrystalline silicon upon the heat treatment time length when, after the execution of the steps from the step of Fig. 1(a) to the step of Fig. 2(i), heat treatment has been performed in a nitrogen atmosphere of 430 °C;
Fig. 4 is a view illustrating a part of the steps that are executed in a second embodiment of the present invention;
Fig. 5 is a view illustrating a part of the steps that are executed in a third embodiment of the present invention; and
Fig. 6 is a graphic diagram illustrating the dependency of the sheet resistivity of the polycrystalline silicon upon the heat treatment time length when, after the execution of the step of Fig. 5, heat treatment has been performed in a nitrogen atmosphere of 430 °C.

### Best Mode For Carrying Out The Invention

Embodiments of the present invention will now be explained with reference to the drawings.

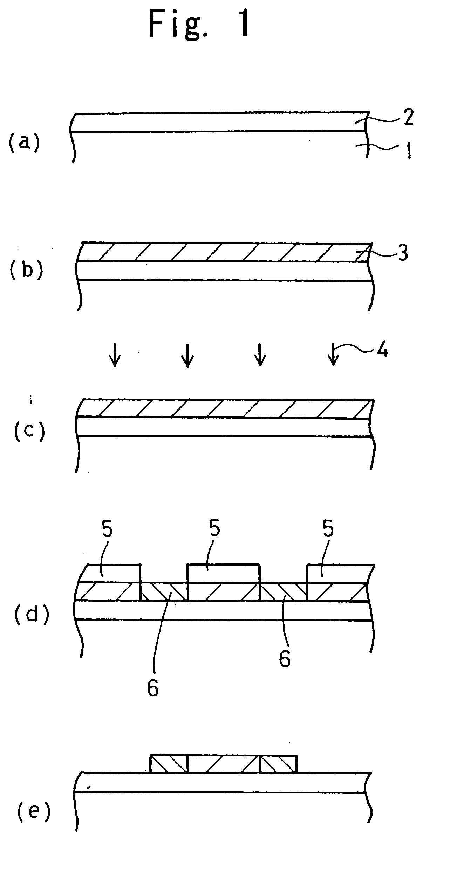

Figs. 1(a) to 1(e) are sequential order step sectional views illustrating a manufacturing method for manufacturing a semiconductor integrated circuit according to a first embodiment of the present invention. First, as in Fig. 1(a), an insulative film 2 is formed on a surface of a silicon substrate 1. Next, as in Fig. 1(b), a polycrystalline silicon film 3 having a thickness of approximately 350 nm is deposited on the insulative film 2 by a pressure reduction CVD method. Next, as in Fig. 1(c), phosphorus ions 4 are implanted into the polycrystalline silicon film 3 by an ion implantation method. It is to be noted that the dose of the phosphorus is determined according to a desired value of sheet resistivity.

Next, as in Fig. 1(d), a CVD oxide film is deposited on the polycrystalline silicon film 3 and patterning is performed of it to thereby form a CVD oxide film mask 5. Subsequently, predeposition is performed at 920 °C using POCl₃ or the like to thereby form low-resistance polycrystalline regions 6 at positions where contacts are provided later.

Next, as in Fig. 1(e), after removal of the CVD oxide film mask 5, patterning is performed of the polycrystalline silicon film 3 that includes the low-resistance polycrystalline silicon region 6.

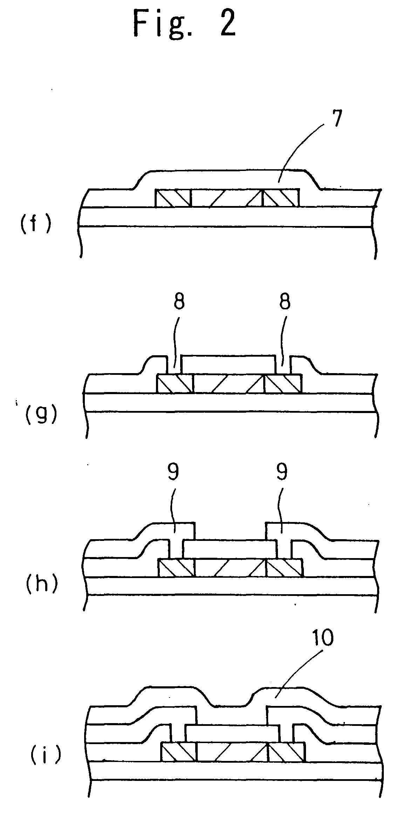

Next, as in Fig. 2(f), an inter-layer insulative film 7 is formed.

Next, as in Fig. 2(g), contact holes are formed in the inter-layer insulative film 7.

Next, as in Fig. 2(h), after having formed an aluminium film on the entire surface of the resulting structure, patterning is performed of it to thereby form an aluminium wiring 9.

Next, as in Fig. 2(i), a plasma silicon nitride film 10 is formed on the aluminium wiring by a plasma CVD method.

Next, subsequently to the execution of the step illustrated in Fig. 2(i), or after the formation of a pad on the plasma silicon nitride film or otherwise at least after the formation of the plasma silicon nitride film, heat treatment of 430 °C is performed.

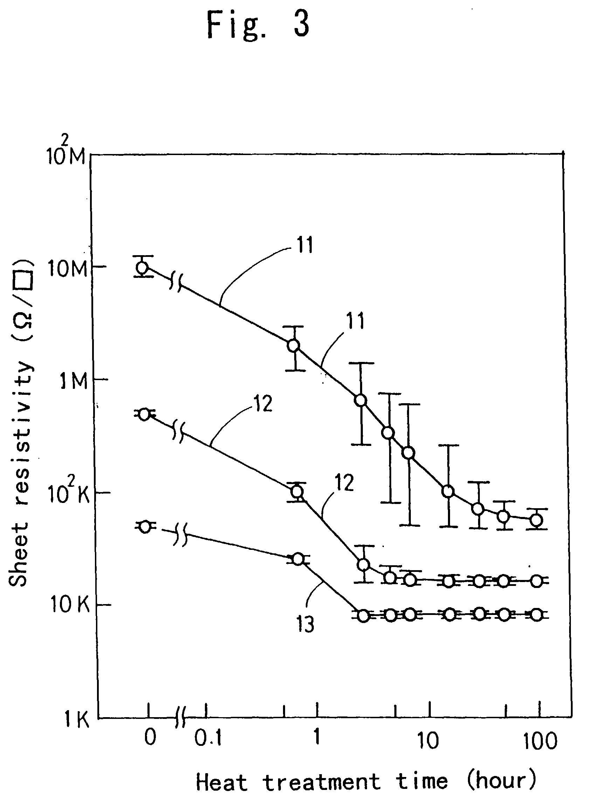

Fig. 3 is a graph showing the dependency of the sheet resistivity of the polycrystalline silicon upon the heat treatment time length when heat treatment of 430 °C has been performed in an atmosphere of nitrogen after the execution of the steps illustrated in Figs. 1(a) to 2(i).

The white circular marks that are plotted in the graphic diagram represent the average values of the sheet resistivities within the substrate and the error bars that correspond to each white circular mark represent maximum and minimum values of the sheet resistivities within the substrate. In all cases of the phosphorus dose of 2E14 (cm⁻²) (11), the phosphorus dose of 3E14 (cm⁻²) (12) and the phosphorus dose of 4E14 (cm⁻²) (13) in the step illustrated in Fig. 1(c), the sheet resistivity at first sharply decreases with an increase in the heat treatment time length and comes to exhibit almost no variation after the lapse of a certain point in time of the heat treatment time length. Also, in a range wherein the sheet resistivity sharply decreases with an increase in the heat treatment time length, the variation in the sheet resistivity is very large whereas, in a range that corresponds to the certain point in time and its succeeding portion of the heat treatment time length, wherein the sheet resistivity exhibits almost no variation, the variation in the sheet resistivity becomes lower. Also, the heat treatment time length portion during which the sheet resistivity comes to exhibit no variation with respect to the lapse of the heat treatment time length and hence the variation in the sheet resistivity becomes smaller with respect thereto comes to increase with a decrease in the phosphorus dose.

From the above-mentioned viewpoint, when the phosphorus dose in the step illustrated in Fig. 1(c) is 4E14 (cm⁻²) or more, the performance of the heat treatment at 430 °C for not less than 3 hours can make small the variation in the sheet resistivity with the substrate. In this case, since even if the heat treatment time length varies more or less no variation occurs in the sheet resistivity, the reproducibility thereof is also high. Similarly, when the phosphorus dose is 3E14 (cm⁻²) or more, the performance of the heat treatment at 430 °C for not less than 7 hours is preferable and, when the phosphorus dose is 2E14 (cm⁻²) or more, the performance of the heat treatment at 430 °C for not less than 100 hours is preferable.

Next, a manufacturing method for manufacturing a semiconductor integrated circuit according to a second embodiment of the present invention will be explained.

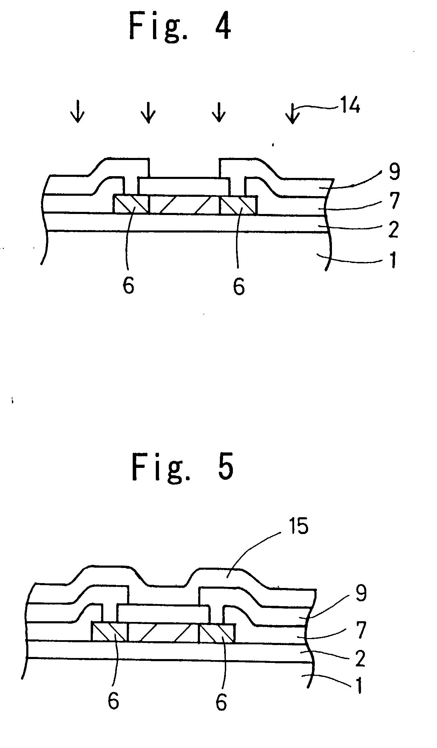

First, in the same way as in the case of the above-mentioned first embodiment of the present invention, the steps illustrated in Figs. 1(a) to 2(h) are executed. Next, in a step that is illustrated in Fig. 4, after the temperature of the substrate 1 has been set to be at 430 °C, a gas containing hydrogen atoms such as NH₃ is introduced into an entire surface of the substrate 1 and, by applying a high frequency field, a hydrogen plasma 14 is generated. By executing this step, the same effect as that which has been obtained with the first embodiment having performed a long heat treatment after having formed a plasma silicon nitride film and which is that the variation in the sheet resistivity is decreased whereby the reproducibility thereof becomes high is procured through the execution of a step for which a shorter period of time than that which has been needed in the first embodiment is needed.

Next, a manufacturing method for manufacturing a semiconductor integrated circuit according to a third embodiment of the present invention will be explained.

First, in the same way as in the case of the above-mentioned first embodiment of the present invention, the steps illustrated in Figs. 1(a) to 2(h) are executed. Next, in a step that is illustrated in Fig. 5, with the temperature of the substrate 1 being maintained to be at 400 °C or so, by a film forming method causing the generation of no plasma, such as a normal pressure CVD, a PSG film 15 is formed over an entire surface of the substrate 1 and this PSG film is used as a passivation film.

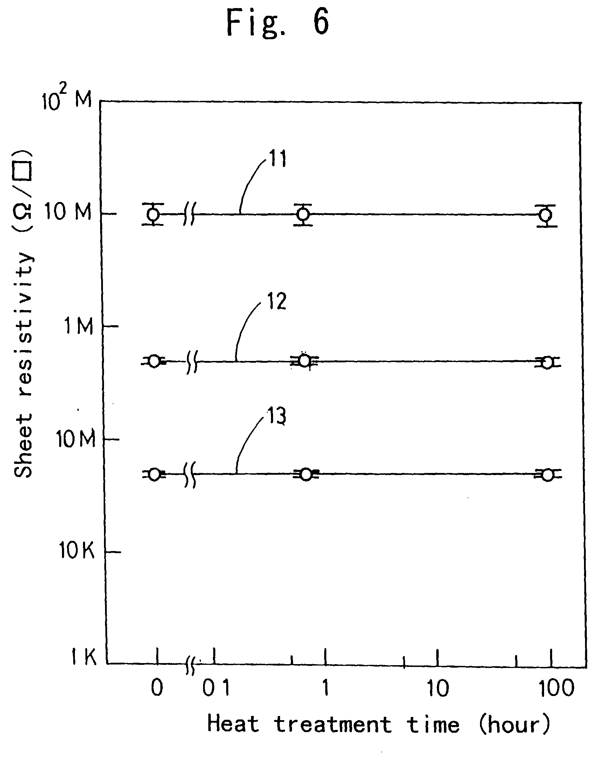

Fig. 6 is a graph showing the dependency of the polycrystalline silicon sheet resistivity upon the heat treatment time length when heat treatment has been performed in a nitrogen atmosphere of 430 °C after the execution of the step illustrated in Fig. 5. The white round marks that are plotted in the graphic diagram represent the average values of the sheet resistivities within the substrate and the error bars that correspond to each white round mark represent maximum and minimum values of the sheet resistvities within the substrate. In all cases of the phosphorus dose of 2E14 (cm⁻²) (11), the phosphorus dose of 3E14 (cm⁻²) (12) and the phosphorus dose of 4E14 (cm⁻²) (13) in the step illustrated in Fig. 1(c), the sheet resistivity of the polycrystalline silicon does not depend on the heat treatment time length and is fixed while exhibiting no variation with its degree of variation remaining to be low. Accordingly, after the execution of the step of Fig. 5, it is sufficient to perform for such a short time period as 30 minutes or so the heat treatment of from 400 °C to 480 °C that is intended to be performed for alloying that is for the purpose of decreasing the contact resistance between the aluminium wiring 9 and the low-resistance polycrystalline silicon region 6.

As stated above, according to the third embodiment of the present invention, there is obtained a semiconductor integrated circuit wherein the variation in the sheet resistivity of the polycrstalline silicon is very low in degree and the reproducibility of the sheet resistivity is very high.

### Industrial Availability

As has been explained above, in the semiconductor integrated circuit that uses a polycrystalline silicon film as the resistance element, the highly reproducible resistance element with a low degree of variation in the sheet resistivity according to the present invention exhibits a good deal of effect.

## Claims

1. A manufacturing method for manufacturing a semiconductor integrated circuit, comprising a step of forming an insulative film on a surface of a substrate, a step of forming a polycrystalline silicon film on the insulative film, a step of doping a low-concentration first conductivity type impurity into the polycrystalline silicon, a step of providing a low-resistance polycrystalline silicon region by doping a high-concentration first conductivity type impurity into a part of the polycrystalline silicon film having the low-concentration first conductivity type impurity doped therein, a step of performing patterning with respect to the polycrystalline silicon film, a step of forming an inter-layer insulative film over the polycrystalline silicon film, a step of forming a contact hole in the inter-layer insulative film located over the polycrystalline silicon film, a step of providing a metal wiring with respect to the contact hole, a step of forming a silicon nitride film on the metal wiring by the use of a plasma CVD method, and a step of, after having formed the silicon nitride film, performing heat treatment with respect to the resulting structure at a temperature of from 400 °C to 480 °C.

2. A manufacturing method for manufacturing a semiconductor integrated circuit, comprising a step of forming an insulative film on a surface of a substrate, a step of forming a polycrystalline silicon film on the insulative film, a step of doping a low-concentration first conductivity type impurity into the polycrystalline silicon, a step of providing a low-resistance polycrystalline silicon region by doping a high-concentration first conductivity type impurity into a part of the polycrystalline silicon film having the low-concentration first conductivity type impurity doped therein, a step of performing patterning with respect to the polycrystalline silicon film, a step of forming an inter-layer insulative film over the polycrystalline silicon film, a step of forming a contact hole in the inter-layer insulative film located over the polycrystalline silicon film, a step of providing a metal wiring with respect to the contact hole, a step of forming a silicon nitride film on the metal wiring by the use of a plasma CVD method, and a step of, after having formed the metal wiring and before forming the silicon nitride film, performing hydrogen plasma treatment with respect to the resulting structure with the temperature of the substrate being kept in a range of from 400 °C to 480 °C.

3. A manufacturing method for manufacturing a semiconductor integrated circuit, comprising a step of forming an insulative film on a surface of a substrate, a step of forming a polycrystalline silicon film on the insulative film, a step of doping a low-concentration first conductivity type impurity into the polycrystalline silicon, a step of providing a low-resistance polycrystalline silicon region by doping a high-concentration first conductivity type impurity into a part of the polycrystalline silicon film having the low-concentration first conductivity type impurity doped therein, a step of performing patterning with respect to the polycrystalline silicon film, a step of forming an inter-layer insulative film over the polycrystalline silicon film, a step of forming a contact hole in the inter-layer insulative film located over the polycrystalline silicon film, a step of providing a metal wiring with respect to the contact hole, a step of forming a PSG film on the metal wiring by the use of a method that uses no plasma, and a step of thereafter performing heat treatment with respect to the resulting structure at a temperature of from 400 °C to 480 °C.
